## Europäisches Patentamt
## European Patent Office
## Office européen des brevets

(19)

(11) Numéro de publication : **0 164 283**
**B1**

(12)

# FASCICULE DE BREVET EUROPÉEN

(45) Date de publication du fascicule du brevet :
09.08.89

(51) Int. Cl.⁴ : **H 03 H 17/04**

(21) Numéro de dépôt : **85400846.3**

(22) Date de dépôt : **30.04.85**

(54) Filtre numérique résonant.

(30) Priorité : **21.05.84 FR 8407846**

(43) Date de publication de la demande :
**11.12.85 Bulletin 85/50**

(45) Mention de la délivrance du brevet :
**09.08.89 Bulletin 89/32**

(84) Etats contractants désignés :
**BE CH DE GB LI NL SE**

(56) Documents cités :
**US–A– 3 543 012**
**US–A– 3 619 586**
**TELECOMMUNICATIONS & RADIO ENGINEERING,
vol. 35/36, no. 10, octobre 1981, pages 131-133, Scripta
Publishing Co., Silver Spring, Maryland, US; B.I.
YAVORSKIY et al.: "Design of Chebyshev digital
bandpass filters"**

(73) Titulaire : **SCHLUMBERGER INDUSTRIES**
**50, avenue Jean Jaurès**
**F-92120 Montrouge (FR)**

(72) Inventeur : **Benkara, Ferial**
**16, rue des Buttes**
**F-92220 Bagneux (FR)**
Inventeur : **Campbell, Daniel**
**3400 Palos Verdes Dr. N**
**Palos Verdes East CA 90274 (US)**

(74) Mandataire : **Bentz, Jean-Paul**
**SCHLUMBERGER INDUSTRIES Propriété intellectuelle Groupe Electricité B.P. 620-02**
**F-92542 Montrouge Cédex (FR)**

Jouve, 18, rue St-Denis, 75001 Paris, France

**Description**

La présente invention concerne un filtre numérique récursif comprenant au moins une première cellule de filtrage dont la fonction de transfert, dans une représentation complexe en Z, à la forme générale $H(Z) = (A_0 - A_0 \cdot Z^{-2})/(1 + C_4 \cdot Z^{-1} + C_5 \cdot Z^{-2})$ et comporte deux zéros correspondant aux solutions de l'équation : $A_0 - A_0 \cdot Z^{-2} = 0$, et deux pôles correspondant aux solutions de l'équation : $1 + C_4 \cdot Z^{-1} + C_5 \cdot Z^{-2} = 0$, les pôles et les zéros étant inscrits dans un disque délimité par un cercle de rayon unité centré sur l'origine des axes réel et imaginaire du plan complexe, les zéros étant disposés aux points de l'axe réel d'abscisses respectives $-1$ et $+1$ et les pôles étant représentés par des complexes conjugués dont le rayon polaire est suffisamment proche de l'unité pour que cette cellule de filtrage réalise un filtrage passe bande autour d'une fréquence centrale, et dont les arguments sont, en valeur absolue, représentatifs de la fréquence centrale de travail de cette cellule.

Les filtres numériques dits « du deuxième ordre », ayant une fonction de transfert de ce type, ou utilisant des cellules de filtrage du deuxième ordre, caractérisées par une telle fonction de transfert, sont bien connus et peuvent être réalisés matériellement de multiples façons, également bien connues de l'homme de l'art.

Des filtres de ce type, ou leur réalisation, sont par exemples décrits, notamment, dans la revue « Proceedings of the nat. electr. conference, vol 25, 8-10 Dec. 1969 pp 691 », dans la revue « IEEE Transactions on Acoustics, Speech, and Signal Processing, vol. ASSP-22, N° 6, Dec. 1974, pp 456 », dans la revue « Journal of the Audio Engineering Society, 1979 October, vol. 27, N° 10, pp 793 » et dans les brevets américains US 3 619 586 et US 4 422 156 et cependant, bien que connus dans leur forme générale et sous des formes de réalisation spécifiques, ces filtres constituent une famille infinie dont les éléments connus ou théoriquement dérivables de la forme générale se distinguent fortement les uns des autres à de multiples points de vue, en particulier par les valeurs des coefficients de leur fonction de transfert, dont dépendent leurs caractéristiques de filtrage, par leurs applications possibles, et par leur aptitude à être mis en œuvre au moyen d'un matériel déterminé.

En particulier, le brevet US-A-3 619 586 décrit un filtre numérique universel susceptible, notamment, d'effectuer un filtrage passe-bande autour d'une fréquence centrale réglable, et sur une largeur de bande également réglable.

Cependant, en dépit de l'intérêt de l'enseignement de ce brevet, le filtre passe-bande qu'il décrit, en référence à sa figure 3, présente une structure relativement complexe, nécessitant six sommateurs élémentaires, quatre multiplieurs et un décaleur ; de plus, ce filtre ne permet pas d'obtenir séparément un réglage de la fréquence centrale et un réglage de la largeur de bande.

Dans ce contexte, un premier but de l'invention est de proposer un filtre numérique susceptible d'être mis en œuvre au moyen d'un matériel simple, en particulier au moyen d'un circuit intégré unique, et de permettre des réglages indépendants de la fréquence centrale et de la largeur de bande.

A cette fin, le filtre de l'invention est essentiellement caractérisé en ce qu'il comprend des moyens de traitement recevant directement les premier $(A_0)$, quatrième $(C_4)$ et cinquième $(C_5)$ coefficients de la fonction de transfert, en ce que le quatrième coefficient $(C_4)$ de la fonction de transfert est choisi entre 2 et $-2$, et en ce que le cinquième coefficient $C_5$ de la fonction de transfert est supérieur à 0.8, ce dont il résulte que des réglages de la fréquence centrale de la cellule de filtrage d'une part, et du gain et de la largeur de bande de cette cellule d'autre part, peuvent être effectués pratiquement indépendamment l'un de l'autre en choisissant, indépendamment l'un de l'autre, le quatrième coefficient d'une part et le cinquième coefficient d'autre part.

Un second but de l'invention est de proposer un filtre numérique programmable n'exigeant que des opérations de calcul simples et en nombre restreint.

A cette fin, le filtre de l'invention est essentiellement caractérisé en ce que le cinquième coefficient $C_5$ de la fonction de transfert est choisi comme étant égal à 1-2PUISSANCE(-K), où K est un entier, ce dont il résulte d'une part que la largeur de bande de la première cellule de filtrage, apte à constituer une cellule programmable, peut être réglée dans des proportions relativement grandes par un choix de l'entier K dans une plage relativement faible et d'autre part que le produit $C_5 \cdot Z^{-2}$ peut être obtenu directement par un décalage binaire et une seule somme algébrique.

Le filtre numérique peut en fait comprendre plusieurs cellules de filtrage en cascade, par exemple deux cellules dont les pôles ont sensiblement le même rayon, et qui ont ainsi sensiblement la même bande passante et le même gain.

Les arguments positifs des pôles de ces deux cellules peuvent présenter entre eux une différence inférieure à l'un quelconque de ces arguments, les cellules ayant ainsi des fréquences de résonance différentes dont la différence est inférieure à l'une quelconque de ces fréquences.

En particulier, la différence de fréquence des deux cellules peut être inférieure à 1.5 fois la largeur de la bande passante de chaque cellule, d'où il résulte que le gain global des deux cellules en cascade est au moins approximativement constant dans la plage de fréquence comprise entre les fréquences de résonance des deux cellules.

On peut ainsi notamment prévoir que l'entier K déterminant le cinquième coefficient soit fixé à la même valeur pour les deux cellules, qui ont ainsi la même bande passante et le même gain, quelles que soient leurs fréquences de résonance respectives.

Si en outre la différence des fréquences de résonance des deux cellules est voisine de 1.3 fois la largeur de bande de chaque cellule, le gain global des deux cellules en cascade est alors constant dans la plage de fréquence comprise entre les fréquences de résonance des deux cellules.

On peut par ailleurs prévoir que les premier et troisième coefficients $A_0$ et $A_2$ de la fonction de transfert de la première cellule au moins soient des fonctions décroissantes de l'entier K, le gain de cette cellule à la fréquence de résonance étant ainsi constant et indépendant à la fois de cette fréquence de résonance et de la largeur de bande de la cellule.

En particulier, on peut prévoir que ces coefficients $A_0$ et $A_2$ soient exprimés en fonction de puissances de 2 de l'entier K, de sorte que le gain est aussi constant que possible et que les calculs sont allégés au maximum par le recours extensif aux opérations de décalage binaire.

D'autres caractéristiques et avantages de l'invention ressortiront clairement de la description qui en est faite ci-après, à titre indicatif et nullement limitatif, en référence aux dessins annexés, parmi lesquels :

la figure 1 est un schéma représentatif d'un filtre ou d'une cellule de filtrage du deuxième ordre de l'art antérieur,

la figure 2 est un schéma représentatif d'un filtre ou d'une cellule de filtrage selon l'un des modes de réalisation de l'invention,

la figure 3 est une représentation, dans le plan complexe Z, du fonctionnement d'un filtre à deux cellules, conforme à l'un des modes de réalisation de l'invention,

la figure 4 est un diagramme gain-fréquence des cellules de filtrage et du filtre correspondant à la représentation de la figure 3,

la figure 5 est un schéma de ce même filtre, représentant les deux cellules de filtrage montées en cascade.

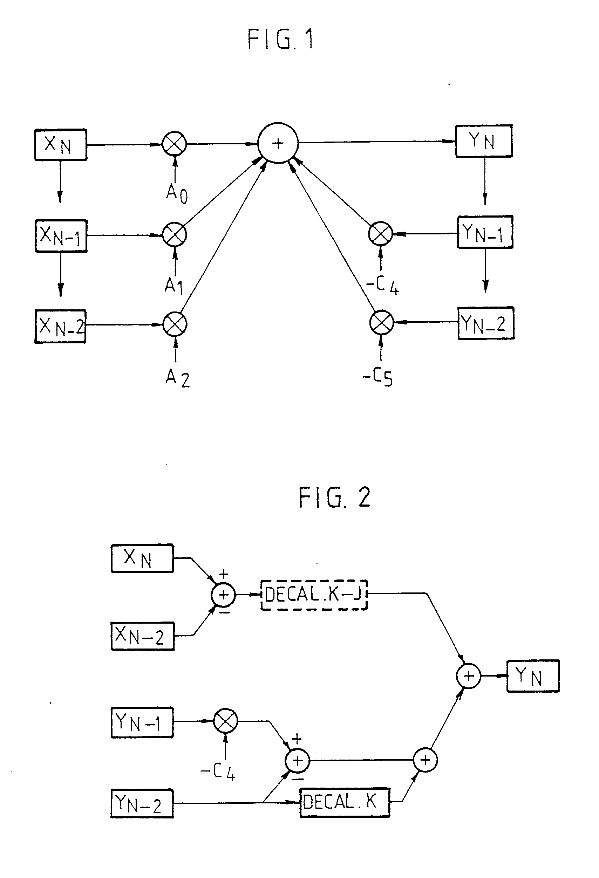

La figure 1 représente, de façon générale, une cellule de filtrage numérique du deuxième ordre.

Une telle cellule reçoit, à une fréquence d'échantillonnage Fe, des échantillons numériques d'entrée successifs binaires $X_N$, et produit des échantillons numériques de sortie successifs binaires $Y_N$.

La production des échantillons de sortie $Y_N$ au moyen des échantillons d'entrée $X_N$ suppose l'emploi des échantillons d'entrée antérieurs $X_{N-1}$, et $X_{N-2}$ ainsi que des échantillons de sortie antérieurs $Y_{N-1}$ et $Y_{N-2}$.

L'échantillon d'entrée $X_{N-1}$ est celui qui a précédé immédiatement l'échantillon d'entrée $X_N$ à la fréquence d'échantillonage ; de même pour $X_{N-2}$ par rapport à $X_{N-1}$, pour $Y_{N-1}$ par rapport à $Y_N$ et pour $Y_{N-2}$ par rapport à $Y_{N-1}$.

Les échantillons d'entrée $X_N$, $X_{N-1}$ et $X_{N-2}$ sont multipliés par des premier, second et troisième coefficients respectifs $A_0$, $A_1$ et $A_2$ ; les échantillons de sortie $Y_{N-1}$ et $Y_{N-2}$ sont multipliés par des quatrième et cinquième coefficients respectifs $C_4$ et $C_5$ changés de signe, et l'échantillon de sortie $Y_N$ est obtenu comme la somme algébrique de l'ensemble des produits effectués.

La fonction de transfert complexe d'une telle cellule de filtrage, traditionnellement désignée par H(Z), est donnée par le rapport : $H(Z) = (A_0 + A_1 \cdot Z^{-1} + A_2 \cdot Z^{-2})/(1 + C_4 \cdot Z^{-1} + C_5 \cdot Z^{-2})$ où $Z^{-1}$ représente un retard correspondant à un cycle d'un signal ayant pour fréquence la fréquence d'échantillonnage, c'est-à-dire au délai existant par exemple entre les échantillons $X_{N-1}$ et $X_N$.

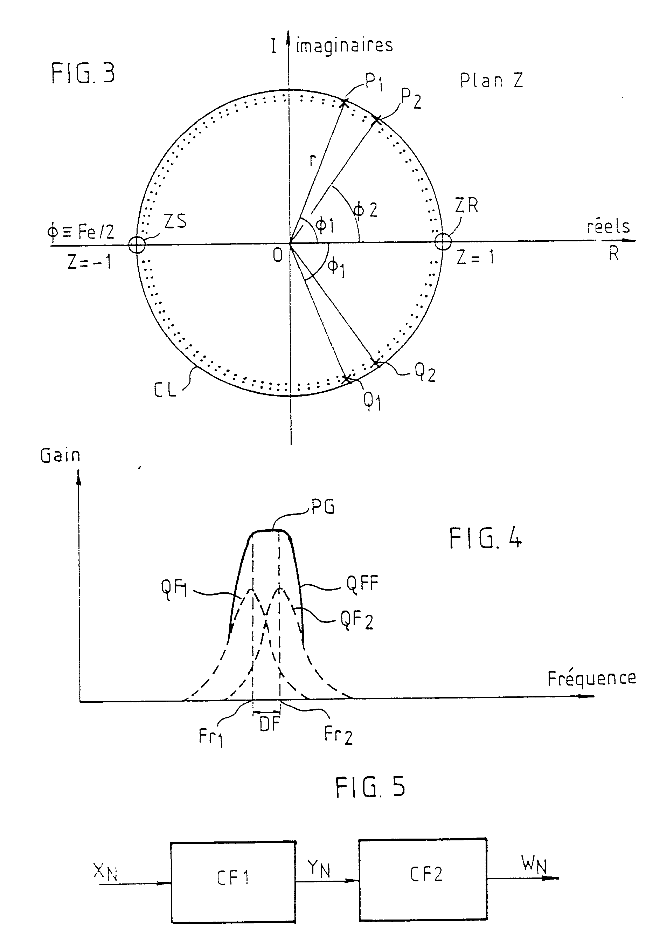

Dans une représentation dans le plan orthonormé des nombres complexes Z, déterminé par l'axe R des nombres réels et l'axe I des nombres imaginaires purs, la fonction de transfert H(Z) est caractérisée par deux pôles (tels que $P_1$, $Q_1$ ou $P_2$, $Q_2$ sur la figure 3) et deux zéros (tels que ZR, ZS sur la figure 3).

Les zéros sont solutions de l'équation :

$$A_0 + A_1 \cdot Z^{-1} + A_2 \cdot Z^{-2} = 0$$

et les pôles sont solutions de l'équation :

$$1 + C_4 \cdot Z^{-1} + C_5 \cdot Z^{-2} = 0$$

Pour que la suite des échantillons de sortie $Y_N$ successifs ne diverge pas, il est nécessaire de choisir les coefficients $A_0$, $A_1$, $A_2$, $C_4$ et $C_5$ de manière que les pôles et les zéros soient inscrits dans le disque délimité par le cercle CL de rayon unité centré sur l'origine O des axes R et I. Les pôles (tels que $P_1$, $Q_1$ sur la figure 3) sont représentés par des nombres complexes conjugués définis par un rayon polaire (tel que r sur la figure 3), et un argument (tel que $\varnothing 1$ ou $-\varnothing 1$). Pour des valeurs du module du rayon r suffisamment différentes de zéro, la cellule de filtrage réalise un filtrage passe-bande autour d'une fréquence centrale de travail. Plus le module du rayon polaire r est proche de l'unité, plus grande est la sélectivité de la cellule.

La valeur absolue (telle que $\varnothing 1$) de l'argument de pôles est représentative de la fréquence centrale de travail de la cellule de filtrage.

La fréquence d'échantillonage Fe correspond à un tour complet dans le sens trigonométrique, c'est-à-dire à 360°, autour de l'origine O, à partir du point Z = 1 d'abcisse unité sur l'axe des réels.

En vertu du théorème de Shannon, un filtrage peut être effectué avec toute fréquence centrale comprise entre 0 et la moitié de la fréquence d'échantillonnage Fe.

EP 0 164 283 B1

La cellule de filtrage ou le filtre conformes à l'invention sont tels que :

$$A_2 = -A_0$$
$$A_1 = 0 \text{ et}$$
$$C_5 = 0.8$$

De préférence, $A_2 = -A_0$, $A_1 = 0$ et $C_5$ est supérieur à 0.9.

Il résulte en premier lieu de ces caractéristiques, que les zéros ZR, ZS de la fonction de transfert H(Z) de la cellule considérée sont disposés aux points $Z = 1$ et $Z = -1$, d'abscisses respectives $+1$ et $-1$, de l'axe R, ou à proximité immédiate de ces points.

Il résulte ensuite de ces mêmes caractéristiques que la cellule considérée réalise un filtrage passe-bande par résonance dont la fréquence centrale est la fréquence de résonance, et que la largeur de bande de cette cellule et son gain pour un signal à la fréquence de résonance sont pratiquement indépendants de la fréquence de résonance et ne dépendent essentiellement que de la différence $1-C_5$.

De plus la fonction de transfert d'une cellule de filtrage du deuxième ordre présentant ces caractéristiques a la forme :

$$H(Z) = A_0 \cdot (1 - Z^{-2})/(1 + C_4 \cdot Z^{-1} + C_5 \cdot Z^{-2}) \tag{1}$$

Ainsi, au lieu de requérir 5 multiplications et 4 additions, comme la cellule de filtrage représentée sur la figure 1, la cellule présentant cette dernière fonction de transfert ne requiert que 3 multiplications et 3 additions.

Cependant, la réalisation de cette cellule de filtrage peut encore être sensiblement simplifiée, en particulier dans le but de réaliser une cellule de filtrage programmable, en donnant au cinquième coefficient $C_5$ la valeur :

$$C_5 = 1 - 2^{-K}$$

où K est un entier par exemple supérieur à 4.

La fonction de transfert devient alors :

$$H(Z) = A_0 \cdot (1 - Z^{-2})/(1 + C_4 \cdot Z^{-1} + Z^{-2} - 2^{-K} \cdot Z^{-2}) \tag{2}$$

Dans le cas où le coefficient $A_0$ est égal à l'unité, une telle cellule de filtrage correspond au schéma de la figure 2 dans lequel le bloc « DECAL.K — J » est court-circuité.

Dans une telle cellule, l'échantillon de sortie $Y_N$ est donné par :

$$Y_N = X_N - X_{N-2} - C_4 \cdot Y_{N-1} - Y_{N-2} + 2^{-K} \cdot Y_{N-2} \tag{3}$$

Comme le terme $2^{-K}$ peut alors être obtenu directement par un simple décalage binaire de K positions de bits en direction du bit le moins significatif, réalisé par exemple dans le registre à décalage « DECAL K », l'échantillon de sortie $Y_N$ est obtenu au moyen d'une seule multiplication, de 4 additions et d'un décalage. La réduction sensible du nombre de multiplications permet un allègement important du matériel nécessaire à la réalisation d'une telle cellule de filtrage et/ou une augmentation de la vitesse de calcul.

On peut montrer que le quatrième coefficient $C_4$ est donné par la relation :

$$C_4 = -2r \cdot \cos \emptyset,$$

où $\emptyset$ est l'argument de l'un des pôles, de sorte que :

$$C_4 = -2 r \cdot \cos (2 \cdot PI \cdot Fr/Fe)$$

où Fr est la fréquence de résonance désirée, et $PI = 3.14159$.

Pour une cellule de filtrage dont la fonction transfert est donnée par la relation (2) ou correspond à la relation (3), le coefficient $C_4$ peut être assimilé à la valeur :

$$C_4 = (2^{-K} - 2) \cdot \cos (2 \cdot PI \cdot Fr/Fe) .$$

Comme $2^{-K}$ est très petit, le coefficient $C_4$ peut pratiquement être choisi dans la plage de valeurs 2 à $-2$, correspondant à des fréquences de résonance entre Fe/2 et 0, ou a fortiori dans la plage de valeurs plus restreintes de 0 à $-2$, correspondant à des fréquences de résonance entre Fe/4 et 0 comme c'est le cas pour les cellules de filtrage correspondant à l'exemple non limitatif donné à la fin de la présente description.

D'autre part on peut montrer que le gain d'une cellule de filtrage satisfaisant à la relation (2) avec

4

$A_0 = 1$, c'est-à-dire encore à la relation (3), est très voisin de $2^{K+1}$ pour un signal à la fréquence de résonance.

Il en résulte que l'entier K peut être utilisé pour normer le gain de la cellule de filtrage de manière que celle-ci ait un gain constant quels que soient l'entier K et le coefficient $C_4$, c'est-à-dire quelles que soient la bande passante et la fréquence de résonance de cette cellule.

Ceci est obtenu en dotant cette cellule d'une fonction de transfert directement dérivée de relation (2) en donnant à $A_0$ une valeur proportionnelle à $2^{-(K+1)}$, et par exemple une fonction de transfert :

$$H(Z) = 2^{-K+J} \cdot (1 - Z^{-2})/(1 + C_4 \cdot Z^{-1} + Z^{-2} - 2^{-K} \cdot Z^{-2}) \qquad (4)$$

où J est un entier positif ou négatif indépendant de K.

Dans une telle cellule, les échantillons de sortie sont donnés par la relation :

$$Y_N = 2^{-K+J} \cdot (X_N - X_{N-2}) - C_4 \cdot Y_{N-1} - Y_{N-2} + 2^{-K} \cdot Y_{N-2} \qquad (5)$$

Une telle cellule est représentée sur la figure 2 sur laquelle le registre « DECAL.K » opère un décalage binaire correspondant à la multiplication par $2^{-K}$ (c'est-à-dire un décalage de K positions de bits) et sur laquelle le registre « DECAL.K — J » opère un décalage binaire correspondant à la multiplication par $2^{-K+J}$ (c'est-à-dire un décalage de K — J positions de bits dans un sens ou J — K dans l'autre).

Pour tout entier J constant, la largeur de bande de la cellule de filtrage dont la fonction de transfert satisfait à la relation (4), et sa fréquence de résonance, peuvent être réglées indépendamment en choisissant respectivement l'entier K et le coefficient $C_4$, sans que le gain de cette cellule pour la fréquence de résonance choisie soit modifié.

Dans la pratique, il est souvent nécessaire, pour réaliser un filtre, de monter plusieurs cellules de filtrage en cascade, et en particulier deux cellules CF1, CF2 comme le montre la figure 5. La seconde cellule CF2 produit des échantillons de sortie $W_N$ en utilisant comme échantillons d'entrée les échantillons de sortie $Y_N$ de la première cellule CF1.

Dans ce cas il est possible non seulement de tirer parti des avantages de l'invention qui ont été présentés jusqu'à présent, mais aussi de bénéficier de l'avantage supplémentaire de pouvoir réaliser de façon simple des caractéristiques de filtrage se distinguant par un palier de gain PG sur un domaine de fréquence DF compris entre les fréquences de résonance Fr1 et Fr2 de deux cellules CF1 et CF2, comme le montre la figure 4.

Ceci est obtenu en donnant aux cellules de filtrage CF1 et CF2 des fréquences de résonance voisines et des largeurs de bande sensiblement identiques.

On pourra par exemple choisir des largeurs de bandes strictement identiques et des fréquences de résonance respectives Fr1, Fr2 telles que la différence DF de ces fréquences soit inférieure à 1,5 fois ou même, plus précisément, voisine de 1,3 fois, la largeur de bande de chaque cellule.

On peut montrer en effet que si les fréquences de résonance Fr1 et Fr2 sont identiques pour des cellules dont les fonctions de transfert satisfont à la relation (2) avec une même valeur du coefficient $A_0$, la largeur de bande LB4 du filtre du quatrième ordre constitué par le montage en cascade des deux cellules CF1 et CF2 du deuxième ordre est liée à la largeur de bande LB2 de chaque cellule par la relation :

$$LB4 = ((2)^{1/2} - 1)^{1/2} \cdot LB2,$$

soit

$$LB4 = 0.644 \cdot LB2 .$$

Or on peut montrer que, si l'on désigne par QFF la caractéristique de filtrage du filtre du $4^e$ ordre de la figure 5, résultant de la superposition des caractéristiques de filtrage QF1 et QF2 des cellules CF1 et CF2 (cf. fig. 4) la caractéristique QFF présente un palier de gain PG parfaitement plat si la différence de fréquence $FD = |Fr1 - Fr2|$ est telle que :

$$DF = 2 \cdot LB4, \quad \text{c'est-à-dire} \quad DF = 1.288 \cdot LB2 .$$

La figure 3 représente, dans le plan complexe, les pôles et les zéros des fonctions de transfert, conformes à la relation (4), des deux cellules CF1 et CF2 présentant les caractéristiques de filtrage respectives QF1 et QF2.

Ces cellules sont définies par une même valeur de l'entier K ; les pôles $P_1$, $Q_1$, $P_2$, $Q_2$ ont même module r ; les zéros des deux cellules sont aux points d'abscisses $+ 1$ et $- 1$ sur l'axe R et les coefficients $C_4$ respectifs des deux cellules sont définis par :

$$C_4 = - 2 r \cdot \cos (2 \cdot PI \cdot Fr1/Fe) = - 2 r \cdot \cos \varnothing 1$$

$$C_4 = -2\,r \cdot \cos\,(2 \cdot PI \cdot Fr2/Fe) = -2\,r \cdot \cos\,\varnothing 2$$

En fait les coefficients $C_4$ sont définis par des mots binaires qui ne représentent les valeurs ci-dessus qu'avec une précision finie.

Cet état de fait est illustré de façon symbolique par un ensemble de points à la périphérie du disque de la figure 3, ces points représentant les seules positions que les pôles peuvent adopter, en raison du caractère discret des coefficients $C_4$ et $C_5$.

A titre d'exemple illustratif et nullement limitatif, un filtre du quatrième ordre pour un récepteur de télécommande centralisée peut être réalisé à partir de deux cellules de filtrage du deuxième ordre CF1 et CF2 ayant les caractéristiques suivantes :

| | |
|---|---|
| Fréquence d'échantillonnage | Fe = 8 192 Hz |
| Valeurs possibles de K | 6 à 9 inclus |
| Valeurs possibles de C4 | 0 à — 2 |
| Codage de C1 | 14 bits |
| Valeurs de J | 3 pour CF1 ; 0 pour CF2 |
| Valeurs possibles de LB4 | 0,02 % à 0,31 % de Fe |
| Fréquence centrale du filtre | 160 à 1 600 Hz |

## Revendications

1. Filtre numérique récursif comprenant au moins une première cellule de filtrage dont la fonction de transfert, dans une représentation complexe en Z, a la forme générale $H(Z) = A_0 - A_0 \cdot Z^{-2})/(1 + C_4 \cdot Z^{-1} + C_5 \cdot Z^{-2})$ et comporte deux zéros correspondant aux solutions de l'équation : $A_0 - A_0 \cdot Z^{-2} = 0$, et deux pôles correspondant aux solutions de l'équation : $1 + C_4 \cdot Z^{-1} + C_5 \cdot Z^{-2} = 0$, les pôles et les zéros étant inscrits dans un disque délimité par un cercle de rayon unité centré sur l'origine des axes réel et imaginaire du plan complexe, les zéros étant disposés aux points de l'axe réel d'abscisses respectives — 1 et + 1 et les pôles étant représentés par des complexes conjugués dont le rayon polaire est suffisamment proche de l'unité pour que cette cellule de filtrage réalise un filtrage passe bande autour d'une fréquence centrale, et dont les arguments sont, en valeur absolue, représentatifs de la fréquence centrale de travail de cette cellule, caractérisé en ce qu'il comprend des moyens de traitement recevant directement les premier ($A_0$), quatrième ($C_4$) et cinquième ($C_5$) coefficients de la fonction de transfert, en ce que le quatrième coefficient $C_4$ de la fonction de transfert est choisi entre 2 et — 2, et en ce que le cinquième coefficient $C_5$ de la fonction de transfert est supérieur à 0,8, ce dont il résulte que des réglages de la fréquence centrale de la cellule de filtrage d'une part, et du gain et de la largeur de bande de cette cellule d'autre part, peuvent être effectués pratiquement indépendamment l'un de l'autre en choisissant, indépendamment l'un de l'autre, le quatrième coefficient d'une part et le cinquième coefficient d'autre part.

2. Filtre numérique suivant la revendication 1, caractérisé en ce que le cinquième coefficient $C_5$ de la fonction de transfert est choisi comme étant égal à 1-2 PUISSANCE (— K), où K est un entier, ce dont il résulte d'une part que la largeur de bande de la première cellule de filtrage, apte à constituer une cellule programmable, peut être réglée dans des proportions relativement grandes par un choix de l'entier K dans une plage relativement faible et d'autre part que le produit $C_5 \cdot Z^{-2}$ peut être obtenu directement par un décalage binaire et une seule somme algébrique.

3. Filtre numérique suivant l'une quelconque des revendications précédentes, caractérisé en ce qu'il comprend également du moins une seconde cellule, semblable à la première et montée en cascade avec elle, et en ce que les arguments positifs des pôles des deux cellules présentent entre eux une différence inférieure à l'un quelconque de ces arguments, les cellules ayant ainsi des fréquences centrales différentes dont la différence est inférieure à l'une quelconque de ces fréquences.

4. Filtre numérique suivant la revendication 3, caractérisé en ce que la différence de fréquence des deux cellules est inférieure à 1,5 fois la largeur de la bande passante de chaque cellule, d'où il résulte que le gain global des deux cellules en cascade est au moins approximativement constant dans la plage de fréquence comprise entre les fréquences centrales des deux cellules.

5. Filtre numérique suivant l'une quelconque des revendications 3 et 4, combinée à la revendication 2, caractérisé en ce que l'entier K est fixé à la même valeur pour les deux cellules, qui ont ainsi la même bande passante et le même gain, quelles que soient leurs fréquences centrales respectives.

6. Filtre suivant la revendication 5, caractérisé en ce que la différence des fréquences centrales des deux cellules est voisine de 1,3 fois la largeur de bande de chaque cellule, le gain global des deux cellules en cascade étant ainsi constant dans la plage de fréquence comprise entre les fréquences centrales des deux cellules.

7. Filtre suivant l'une quelconque des revendications précédentes, combinée à la revendication 2, caractérisé en ce que le premier coefficient $A_0$ de la fonction de transfert, de la première cellule au moins, est une fonction décroissante de l'entier K, d'où il résulte que le gain de cette cellule à la fréquence centrale est constant et indépendant à la fois de cette fréquence centrale et de la largeur de bande de la cellule.

8. Filtre suivant la revendication 7, caractérisé en ce que lesdites fonctions sont des fonctions exprimées par une puissance de 2.

## Claims

1. A digital recursive filter comprising at least a first filter cell whose transfer function, in a complex Z representation, is of the general form $H(Z) = (A_0 - A_0 \cdot Z^{-2})/(1 + C_4 \cdot Z^{-1} + C_5 \cdot Z^{-2})$ and has two zeroes which correspond to the roots of the equation: $A_0 - A_0 \cdot Z^{-2} = 0$, and two poles which correspond to the roots of the equation: $1 + C_4 \cdot Z^{-1} + C_5 \cdot Z^{-2} = 0$, which poles and zeroes are inscribed within a disc bounded by a unit radius circle centered at the origins of the real and imaginary axes of the complex plane, the zeroes being located at points on the real axis with respective abscissae — 1 and + 1 and the poles being represented by complex conjugates, the polar radius of which is close enough to unity for said filtering cell to perform a band-pass filtering about a central frequency, and the arguments of which are, in absolute value, representative of the operating central frequency of said cell, characterized in that it comprises processing means directly provided with the first ($A_0$), fourth ($C_4$) and fifth ($C_5$) coefficients of the transfer function, in that the fourth coefficient $C_4$ of the transfer function is selected to range between 2 and — 2, and in that the fifth coefficient $C_5$ of the transfer function is greater than 0.8, whereby the settings of the central frequency of said cell on the one hand, and of the gain and bandwidth of said cell, on the other hand, can be performed substantially independently from one another by selecting, independently from one another, the fourth coefficient on the one hand, and the fifth coefficient, on the other hand.

2. A digital filter according to claim 1, characterized in that the fifth coefficient $C_5$ of the tranfer function is selected to be equal to 1—2TP-THE-POWER(— K), where K is an integer, whereby, on the one hand, the bandwidth of the first filter cell, which can be designed to be a programable cell, can bz set within relatively large bounds by selecting integer K within a relatively narrow range, and on the other hand, the product $C_5 \cdot Z^{-2}$ can be directly obtained through a bit-shifting and a single algebraic sum.

3. A digital filter according to any of the previous claims, characterized in that it also comprises at least a second cell, similar to and cascaded with the first one, and in that the difference between the positive arguments of the poles of both cells is smaller than any of said arguments, so that the cells have different central frequencies the difference of which is smaller than any of said frequencies.

4. A digital filter according to claim 3, characterized in that the frequency difference of the two cells is smaller than 1.5 times the pass-band of each cell, whereby the overall gain of the two casciaded cells is at least approximately constant within the frequency range comprised between the central frequencies of both cells.

5. A digital filter according to any of claims 3 and 4, in combination with claim 2, characterized in that integer K is set to the same value for each cell, which then have the same bandwidth and gain whatever their respective central frequencies.

6. A filter according to claim 5, characterized in that the difference between central frequencies of both cells is close to 1.3 times the bandwidth of each cell, wherein the overall gain of the two cascaded cells is constant within a frequency range comprised between the central frequencies of both cells.

7. A filter according to any of the previous claims, combined with claim 2, characterized in that the first coefficient $A_0$ of the transfer function of at least the first cell, is a descreasing function of integer K, whereby the gain of said cell at central frequency is constant and both independent of said central frequency and of the bandwidth of the cell.

8. A filter according to claim 7, characterized in that said functions are functions expressed by a power of 2.

## Patentansprüche

1. Digitales rekursives Filter mit wenigstens einer ersten Filterzelle, deren Übertragungsfunktion in einer komplexen Z-Darstellung die allgemeine Form $H(Z) = (A_0 - A_0 \cdot Z^{-2})/(1 + C_4 \cdot Z^{-1} + C_5 \cdot Z^{-2})$ aufweist und zwei den Lösungen der Gleichung: $A_0 - A_0 \cdot Z^{-2} = 0$ entsprechende Nullstellen sowie zwei den Lösungen der Gleichung: $1 + C_4 \cdot Z^{-1} + C_5 \cdot Z^{-2} = 0$ entsprechende Polstellen umfaßt, wobei die Polstellen und die Nullstellen in eine durch einen Kreis mit dem Radius eins abgegrenzten Scheibe eingeschrieben sind, welcher auf den Ursprung der realen Achse und der imaginären Achse der komplexen Ebene zentriert ist, wobei die Nullstellen an den Punkten — 1 und + 1 der reellen Abzissenachse liegen und die Polstellen durch konjugierte komplexe Größen dargestellt sind, deren Polradius dem Wert 1 ausreichend nahe ist, damit diese Filterzelle ein Bandpaß-Filter um eine zentrale Frequenz bildet, und deren Argumente im Absolutwert für die zentrale Betriebsfrequenz dieser Zelle repräsentativ sind, dadurch gekennzeichnet, daß es Verarbeitungsmittel umfaßt, die den ersten Koeffizient ($A_0$), den vierten Koeffizient ($C_4$) sowie den fünften Koeffizient ($C_5$) der Übertragungsfunktion

unmittelbar empfangen, daß der vierte Koeffizient $C_4$ der Übertragungsfunktion zwischen 2 und — 2 gewählt ist und daß der fünfte Koeffizient $C_5$ der Übertragungsfunktion größer als 0.8 ist, woraus folgt, daß Einstellungen der zentralen Frequenz der Filterzelle einerseits sowie des Übertragungsfaktors und der Bandbreite dieser Zelle andererseits praktisch unabhängig voneinander vorgenommen werden können, indem der vierte Koeffizient einerseits und der fünfte Koeffizient andererseits unabhängig voneinander gewählt werden.

2. Digitales Filter nach Anspruch 1, dadurch gekennzeichnet, daß der fünfte Koeffizient $C_5$ der Übertragungsfunktion so ausgewählt wird, daß er gleich einer 1-2 POTENZ (— K) ist, worin K eine ganze Zahl ist, woraus einerseits folgt, daß die Bandbreite der ersten Filterzellen, die dazu geeignet ist, eine programmierbare Zelle zu bilden, in relativ großem Ausmaß durch eine Auswahl der ganzen Zahl K in einem relativ kleinen Bereich eingestellt werden kann, und daß andererseits das Produkt $C_5 \cdot Z^{-2}$ unmittelbar durch eine binäre Verschiebung und durch eine einzige algebraische Summe erhalten werden kann.

3. Digitales Filter nach einem der vorstehenden Ansprüche, dadurch gekennzeichnet, daß es ferner wenigstens eine zweite Zelle umfaßt, die der ersten Zelle gleicht und mit ihr in Kaskade geschaltet ist, und daß die positiven Argumente der Polstellen der beiden Zellen miteinander eine Differenz aufweisen, welche kleiner als jedes dieser Argumente ist, wobei die Zellen auf diese Weise verschiedene zentrale Frequenzen aufweisen, deren Differenz kleiner als jede dieser Frequenzen ist.

4. Digitales Filter nach Anspruch 3, dadurch gekennzeichnet, daß die frequenzdifferenz der beiden Zellen kleiner als das 1.5- fache der Breite des Durchlaßbandes jeder Zelle ist, woraus folgt, daß der Gesamtübertragungsfaktor der in Kaskade geschalteten beiden Zellen in dem zwischen den zentralen Frequenzen der beiden Zellen gelegenen Frenquenzbereich wenigstens annähernd konstant ist.

5. Digitales Filter nach mit Anspruch 2 kombiniertem Anspruch 3 oder 4, dadurch gekennzeichnet, daß die ganze Zahl K für beide Zellen auf demselben Wert festgelegt ist, so daß diese unabhängig von ihrer jeweiligen zentralen Frequenz das selbe Durchlaßband sowie denselben Übertragungsfaktor aufweisen.

6. Filter nach Anspruch 5, dadurch gekennzeichnet, daß die Differenz der zentralen Frequenz der beiden Zellen etwa das 1,3-fache der Bandbreite jeder Zelle beträgt, wobei dann der Gesamtübertragungsfaktor der in Kaskade geschalteten beiden Zellen in dem zwischen den zentralen Frequenzen der beiden Zellen enthaltenen Frequenzbereich konstant ist.

7. Filter nach einem der mit Anspruch 2 kombinierten vorstehenden Ansprüche, dadurch gekennzeichnet, daß wenigstens der erste Koeffizient $A_0$ der Übertragungsfunktion der ersten Zelle eine abnehmende Funktion der ganzen Zahl K ist, woraus folgt, daß der Übertragungsfaktor dieser Zelle für die zentrale Frequenz konstant ist und sowohl von dieser zentralen Frequenz als auch von der Bandbreite der Zelle unabhängig ist.

8. Filter nach Anspruch 7, dadurch gekennzeichnet, daß die genannten Funktionen durch eine Potenz von 2 ausgedrückte Funktionen sind.

FIG. 1

FIG. 2

1

FIG.3

FIG. 4

FIG. 5